# EUROPEAN PATENT APPLICATION

(11) **EP 4 375 335 A1**
(43) Date of publication of application: **29.05.2024**
(21) Application number: 22845899.8
(22) Date of filing: 19.07.2022
(51) Int. Cl.: C08L 83/07, C08L 83/05, C09J 183/05, C09J 183/07, C09K 3/10, H01L 33/56

(54) **ULTRAVIOLET RAY-ACTIVATED LIQUID SILICONE COMPOSITION FOR OPTICAL APPLICATION**

(30) Priority: 19.07.2021 JP 2021118634
(71) Applicant: Momentive Performance Materials Inc., Niskayuna, NY 12309 (US); Otake, Tatsuya, Tokyo 107-6119 (JP)
(72) Inventor: OTAKE Tatsuya, Tokyo 107-6119 (JP)
(74) Representative: Müller-Boré & Partner Patentanwälte PartG mbB
(86) International application number: PCT/JP2022/027972
(87) International publication number: WO 2023/002966

(57) **Abstract**

A UV-curable silicone composition includes (A) an organopolysiloxane containing at least two alkenyl groups bonded to silicon atom; (B) a linear organohydrogenpolysiloxane having at least one Si-H bond in a side chain and having three of more Si-H bonds in total; (C) a siloxane compound having at least two Si-H bonds and having one hydrolyzable group bonded to a siloxane skeleton via a heteroatom-containing structure; and (D) a platinum catalyst, the UV-curable silicone composition being such that the total of the Si-H bonds contained in the components (B) and (C) is 0.1 to 2.0 equivalents relative to 1 equivalent of the alkenyl groups in the component (A), and the ratio of the number of Si-H bonds derived from the component (C) to the number of Si-H bonds in the whole of the composition is 0.2 or more. The silicone composition provides an adhesive that has excellent adhesive characteristics, for example, pot life, curability, adhesion, and reliability.

## Description

### Technical Field

The present invention in particular relates to a UV-active silicone composition for optical applications.

### Background Art

In recent years, attention has been drawn to flat-panel image display devices, such as liquid crystal, plasma, and organic EL image display devices. A flat-panel image display device usually has a pair of substrates at least one of which is light transmissive, such as glass, and a display region (an image display section) between the substrates that has a matrix arrangement of a large number of pixels as active elements composed of semiconductor layers, phosphor layers, or light-emitting layers. In general, the periphery of the display region (the image display section) and a protective member formed of glass or an optical plastic, such as an acrylic resin, is hermetically sealed with an adhesive.

Such an image display device is produced as a thin image display device in which a UV-curable resin composition is interposed between the protective member and the image display section in order to prevent deterioration in visibility (viewability) stemming from factors, such as reflection of outdoor light or indoor lighting. The UV-curable resin compositions used here are UV-curable acrylic resins and UV-curable silicone resin compositions (Patent Literatures 1 and 2).

LED devices are another type of devices that require hermetical sealing with an adhesive. Organic electronic devices, such as organic light emitting diodes (OLED), are extremely vulnerable to moisture and oxygen and are disadvantageous in that the luminous efficiency and the lifespan are significantly reduced when the devices are exposed to the atmosphere or when moisture enters from the outside. To address this, a UV-curable silicone resin composition is used as a sealant that can effectively block the inflow of outside oxygen, moisture, and the like and can thereby enhance the lifespan of organic electronic devices (Patent Literature 3).

UV-curable silicone resin compositions can undergo hydrosilylation reaction with a platinum catalyst and can be cured under relatively mild conditions, although sometimes requiring a means for sufficiently curing portions out of reach of UV rays (Patent Literatures 4 to 8).

### Citation List

### Patent Literature

Patent Literature 1: Japanese Patent Application Kokai Publication No. 2008-282000
Patent Literature 2: Japanese Patent Application Kokai Publication No. H7-134538
Patent Literature 3: Japanese Patent Kohyo Publication No. 2020-504202
Patent Literature 4: Japanese Patent Application Kokai Publication No. 2019-218495
Patent Literature 5: Japanese Patent Application Kokai Publication No. 2019-210351
Patent Literature 6: Japanese Patent Application Kokai Publication No. 2003-213132
Patent Literature 7: Japanese Patent Application Kokai Publication No. 2014-169412
Patent Literature 8: Japanese Patent Application Kokai Publication No. 2013-87199

### Summary of Invention

### Technical Problem

Liquid silicones are used for optical bonding and in LED sealants. UV-curable silicones are sometimes used to enhance workability. The conventional UV-curable silicones, despite the fact that they are UV-active, increase their viscosity only when being mixed or, even if there is no viscosity increase after mixing, the silicones are cured at a very low rate by UV irradiation. Furthermore, these silicones are also unsatisfactory in adhesion to plastics that is required in recent optical bonding. While there are UV-curable silicones, such as those described in the above related-art documents, no liquid silicones exist that are excellent in all of the characteristics required, such as workability, curability, adhesion, and reliability. There is a demand in this regard.

An object of the present invention is to provide an adhesive including a silicone composition that has excellent adhesive characteristics, for example, pot life, curability, adhesion, and reliability.

### Solution to Problem

In order to solve the above-described problems of addition-curable adhesives, the present inventors carried out studies and have identified appropriate vinyl polymers, crosslinking agents, and adhesion-imparting agents. Specifically, the present inventors have found that it is effective to add specific amounts of a polymer having vinyl groups at both ends, a crosslinking agent having a Si-H bond in a side chain, and a silane having a specific structure.

The present invention provides an adhesive including a silicone compound that has excellent pot life, adhesion, curability, and reliability. Specifically, the present invention pertains to the following [1] to [11].
[1] A UV-curable silicone composition including:
   (A) an organopolysiloxane containing at least two alkenyl groups bonded to silicon atom in the molecule;
   (B) a linear organohydrogenpolysiloxane represented by the following formula and having at least three hydrogen atoms bonded to silicon atom in the molecule, (H₍₃₋ₐ₎R¹ₐSiO_{1/2})_{b}(R¹₃SiO_{1/2})_{2-b}(HR¹SiO_{2/2})_{c}(R¹₂SiO_{2/2})_{d}
      (wherein R¹ independently at each occurrence denotes an unsubstituted or substituted, monovalent hydrocarbon group having no aliphatic unsaturated bond, a is 1 or 2, b is 0, 1, or 2, c is a number of 1 or greater, and d is a number of 0 or greater);
   (C) a siloxane compound (not belonging to (A) or (B)) having at least two hydrogen atoms bonded to silicon atom in the molecule and having one hydrolyzable group bonded to a siloxane skeleton via a heteroatom-containing structure; and
   (D) a UV-active hydrosilylation platinum catalyst having a cyclodiene skeleton as a ligand,
   the UV-curable silicone composition being such that the total of the hydrogen atoms bonded to silicon atom contained in the component (B) and the component (C) is 0.1 to 2.0 equivalents relative to 1 equivalent of the alkenyl groups in the component (A), and the ratio of the number of hydrogen atoms bonded to silicon atom derived from the component (C) to the number of hydrogen atoms bonded to silicon atom in the whole of the composition is 0.2 or more.
[2] The UV-curable silicone composition described in [1], wherein the component (A) is a linear organopolysiloxane.
[3] The UV-curable silicone composition described in [1] or [2], wherein the component (D) is trimethyl(methylcyclopentadienyl)platinum.
[4] The UV-curable silicone composition described in any one of [1] to [3], wherein the component (C) is a reaction product of a cyclic organohydrogenpolysiloxane with a silane compound having an acrylic group or a methacrylic group.
[5] The UV-curable silicone composition described in any one of [1] to [4], which has a penetration of 10 or more after being cured.
[6] The UV-curable silicone composition described in any one of [1] to [5], wherein an equalization between storage elastic modulus G' and loss elastic modulus G" is reached in 30 minutes or less at 23°C after UV irradiation.
[7] The UV-curable silicone composition described in any one of [1] to [6], which has a viscosity of 50 Pa s or less after being stored under dark conditions at 80°C for one week.
[8] The UV-curable silicone composition described in any one of [1] to [7], wherein the components (A) and (B) both have a phenyl group and the refractive index of a cured product is 1.56 or less.
[9] The UV-curable silicone composition described in any one of [1] to [8], which is used for bonding or sealing in an image display device.
[10] An image display device having a joint formed using the UV-curable silicone composition described in any one of [1] to [8].
[11] An LED device having a seal formed using the UV-curable silicone composition described in any one of [1] to [8].

### Description of Embodiments

The present invention pertains to a UV-curable silicone composition including:
(A) an organopolysiloxane containing at least two alkenyl groups bonded to silicon atom in the molecule;
(B) a linear organohydrogenpolysiloxane represented by the following formula and having at least three hydrogen atoms bonded to silicon atom in the molecule, (H₍₃₋ₐ₎R¹ₐSiO_{1/2})_{b}(R¹₃SiO_{1/2})_{2-b}(HR¹SiO_{2/2})_{c}(R¹₂SiO_{2/2})_{d}
   (wherein R¹ independently at each occurrence denotes an unsubstituted or substituted, monovalent hydrocarbon group, a is 1 or 2, b is 0, 1, or 2, c is a number of 1 or greater, and d is a number of 0 or greater);
(C) a siloxane compound (not belonging to (A) or (B)) having at least two hydrogen atoms bonded to silicon atom in the molecule and having one hydrolyzable group bonded to a siloxane skeleton via a heteroatom-containing structure; and
(D) a UV-active hydrosilylation platinum catalyst having a cyclodiene skeleton as a ligand,
the UV-curable silicone composition being such that the total of the hydrogen atoms bonded to silicon atom contained in the component (B) and the component (C) is 0.1 to 2.0 equivalents relative to 1 equivalent of the alkenyl groups in the component (A), and the ratio of the number of hydrogen atoms bonded to silicon atom derived from the component (C) to the number of hydrogen atoms bonded to silicon atom in the whole of the composition is 0.2 or more. Hereinafter, the composition of the present invention will be described in detail with respect to each of the items. In the present specification, the term "to" used in numerical ranges means that the numerical ranges include the numbers before and after the "to" as the lower limit and the upper limit.

As used in the present specification, the term "organic group" means a group that contains carbon. The valence of an organic group is described as "n-valent" where n is a natural number. Thus, for example, a "monovalent organic group" means a group that contains carbon and has only one valence bond. The valence bond may be present on an element other than carbon. Even when the valence is not explicitly stated, those skilled in the art can understand the appropriate valence from the context.

As used in the present specification, the term "hydrocarbon group" means a group that contains carbon and hydrogen and results from the detachment of at least one hydrogen atom from the molecule. Examples of such hydrocarbon groups include, but are not particularly limited to, C₁₋₂₀ hydrocarbon groups, such as, for example, aliphatic hydrocarbon groups and aromatic hydrocarbon groups, optionally substituted by one or more substituents. The "aliphatic hydrocarbon groups" may be linear, branched, or cyclic, and may be saturated or unsaturated. The hydrocarbon groups may also contain one or more ring structures. The hydrocarbon groups may have, at a terminal or within the molecular chain, one or more heteroatoms or heteroatom-containing structures, such as nitrogen atoms (N), oxygen atoms (O), sulfur atoms (S), silicon atoms (Si), amide bonds, sulfonyl bonds, siloxane bonds, carbonyl groups, and carbonyloxy groups.

As used in the present specification, the substituents on the "hydrocarbon groups" are not particularly limited and may be selected from, for example, halogen atoms; and C₁₋₆ alkyl groups, C₂₋₆ alkenyl groups, C₂₋₆ alkynyl groups, C₃₋₁₀ cycloalkyl groups, C₃₋₁₀ unsaturated cycloalkyl groups, 5-10 membered heterocyclyl groups, 5-10 membered unsaturated heterocyclyl groups, C₆₋₁₀ aryl groups, and 5-10 membered heteroaryl groups, each optionally substituted by one or more halogen atoms.

In the present specification, alkyl groups and phenyl group may be unsubstituted or substituted unless otherwise specified. Substituents on these groups are not particularly limited and may be, for example, one or more groups selected from halogen atoms, C₁₋₆ alkyl groups, C₂₋₆ alkenyl groups, and C₂₋₆ alkynyl groups.

### Component (A)

The curable polyorganosiloxane composition of the present invention includes, as the component (A), at least one organopolysiloxane containing at least two alkenyl groups bonded to silicon atom in the molecule. The component (A) functions as a base polymer in the curable polyorganosiloxane composition. The alkenyl groups may be present at any positions on the polyorganosiloxane molecule. For example, the alkenyl group may be present at a molecular terminal or may be present as a side chain except the terminals. When the polyorganosiloxane is linear, at least one alkenyl group is preferably present at each of the two terminals of the molecular backbone of the component (A). As used in the present specification, the molecular backbone of the component (A) indicates the longest chain relative to the chains in the molecule of the component (A).

The alkenyl groups are not particularly limited as long as the groups have a carbon-carbon double bond and can undergo an addition reaction. The number of carbon atoms in the alkenyl groups is preferably 2 to 20, preferably 2 to 8, and more preferably 2 to 6. The alkenyl groups may have a branched structure or a ring structure. The carbon-carbon double bond may be located at any position in the hydrocarbon constituting the alkenyl group. From the point of view of reactivity, the carbon-carbon double bond is preferably present at a terminal of the group. A preferred example of the alkenyl groups is vinyl groups because of the easy synthesis of the polyorganosiloxane.

The molecular skeleton of the component (A) is not particularly limited as long as the main skeleton is composed of siloxane bonds. The siloxane in the molecular skeleton may be linear, branched, cyclic, or a combination thereof, and the molecular skeleton that is formed may be three-dimensional. Furthermore, the siloxane skeleton may be interrupted by a divalent organic group. In the present specification, the structure of the siloxane compound may be described using the symbols below to indicate the structural units in the siloxane compound. Hereinafter, these structural units are sometimes written as, for example, "M units", "D units", and the like.
M: -Si(CH₃)₃O_{1/2}
M^{H}: -SiH(CH₃)₂O_{1/2}
M^{Vi}: -Si(CH=CH₂)(CH₃)₂O_{1/2}
D: Si(CH₃)₂O_{2/2}
D^{H}: SiH(CH₃)O_{2/2}
T: Si(CH₃)O_{3/2}
Q: SiO_{4/2}

Hereinafter, the present specification describes the siloxane compounds as being constructed by a combination of the above structural units. The siloxane compounds may include, at least partially, structural units corresponding to the above structural units except that the methyl groups are substituted with other groups, for example, halogens, such as fluorine, and hydrocarbon groups, such as phenyl groups. It is understood that, for example, the notation D^{H}₂₀D₂₀ does not mean that 20 D^{H} units are continuous and followed by a continuation of 20 D units, and the respective units may be arranged in any manner. The T units or the Q units allow the siloxane compounds to take various three-dimensional structures. The component (A) may take a linear molecular skeleton by containing an appropriate combination of the M units, the M^{Vi} units, and the D units.

In one aspect of the present invention, the component (A) is not particularly limited as long as having, on average, two or more alkenyl groups bonded to silicon atom in the molecule and being capable of forming a network structure by undergoing an addition reaction with hydrosilyl groups (Si-H groups) in the component (B) described later. The component (A) typically has, in the molecule, at least two alkenyl-containing siloxane units represented by the general formula (1):

(R¹)ₘ(R²)ₙSiO_{(4-m-n)/2} (1)

(wherein
R¹ is an unsubstituted or substituted, monovalent hydrocarbon group having no aliphatic unsaturated bond;
R² is an alkenyl group;
m is an integer of 0 to 2; and
n is an integer of 1 to 3, with the proviso that m + n is 1 to 3).

A specific example of the component (A) is a linear polyorganosiloxane represented by the following formula (2):

(R^{a})₃₋ₚRₚSi-O-(Si(R)ᵣ(R^{a})₂₋ᵣO)ₙ-SiR_{q}(R^{a})_{3-q} ··· (2)

(wherein
R^{a} independently at each occurrence is an alkenyl group;
R independently at each occurrence is a monovalent organic group;
p and q are each independently 0, 1, or 2;
r independently at each occurrence is 0, 1, or 2; and
n is such a number that the viscosity at 23°C becomes 0.1 to 500 Pa·s). The polyorganosiloxane preferably has a hydrocarbon group as R, in particular, an alkyl group, an alkenyl group, or an aryl group. To control properties, such as refractive index, at least part of the groups R may be aryl groups, such as phenyl groups. A polyorganosiloxane in which the groups R are all methyl is preferably used because of its high availability. From the point of view of refractive index control, it is preferable that 1 to 40 mol% of the groups R be C₆-C₁₂ aryl groups. From the points of view of viscosity and thixotropy, it is preferable that 1 to 20 mol% of the groups R be C₆-C₁₂ aryl groups. Regarding the position of the curable functional groups (alkenyl groups), the polyorganosiloxane is preferably such that r in the formula (2) is 2, that is, the polyorganosiloxane is preferably a linear polyorganosiloxane having at least one curable functional group exclusively at each of the two terminals of the molecule. Hereinafter, the term "curable functional groups" indicate functional groups that can contribute to a curing reaction of the resin and is particularly exemplified by alkenyl groups.

The polyorganosiloxane having alkenyl groups is preferably such that p and q are 2 and r is 2 in the formula (2). Specifically, the polyorganosiloxane having alkenyl groups preferably has one addition reactive group exclusively at each of the molecular terminals, that is, a total of two addition reactive groups, in particular, vinyl groups. Such a polyorganosiloxane usable as the component (a) may be purchased from the market, or curable functional groups may be introduced into a polyorganosiloxane by a known reaction. Compounds as the components (A) may be distinguished by, for example, the positions or the types of substituents, and the degree of polymerization. A single kind of a compound may be used, or a mixture of two or more kinds of compounds may be used. The component (A), which is a polyorganosiloxane, may be a mixture of polyorganosiloxanes with different degrees of polymerization.

The amount in which the component (A) is added is not particularly limited as long as the viscosity of the curable polyorganosiloxane composition permits easy handling. The amount of the component (A) may serve as the criterion based on which other components are appropriately added within the preferred ranges that are individually described below.

### Component (B)

The composition of the present invention includes, as a crosslinking agent, a compound having reactivity with the curable functional groups in the component (A) (hereinafter, the compound is sometimes written simply as the "component (B)"). The addition of the crosslinking agent allows the curable composition to give cured products having good properties, for example, tensile strength and elastic modulus. The component (B) that is used is a linear organohydrogenpolysiloxane that is represented by the following formula (3) and has at least three hydrogen atoms bonded to silicon atom (Si-H bonds) as crosslinking groups in the molecule.

(H₍₃₋ₐ₎R¹ₐSiO_{1/2})_{b}(R¹₃SiO_{1/2})_{2-b}(HR¹SiO_{2/2})_{c}(R¹₂SiO_{2/2})_{d} ··· (3)

(wherein R¹ independently at each occurrence denotes an unsubstituted or substituted, monovalent hydrocarbon group having no aliphatic unsaturated bond, a is 1 or 2, b is 0, 1, or 2, c is a number of 1 or greater, and d is a number of 0 or greater).

The number of the Si-H bonds as crosslinking groups per molecule of the component (B) is three or more including at least one present in a side chain. Thus, the component can provide a network structure by participating in a crosslinking reaction. The components (B) may be used singly, or two or more may be used in combination.

R¹ independently at each occurrence denotes an unsubstituted or substituted, monovalent hydrocarbon group having no aliphatic unsaturated bond. For example, the hydrocarbon groups R¹ are preferably alkyl groups or aryl groups, in particular, methyl groups or phenyl groups. To control properties, such as refractive index, at least part of the groups R may be aryl groups, such as phenyl groups.

The siloxane skeleton in the hydrogenpolyorganosiloxane is a skeleton in which the main part is linear. The backbone of the hydrogenpolyorganosiloxane is a linear skeleton, but the skeleton may have a substituent as a branch structure. The number of the hydrogen groups bonded to silicon atom (equivalent to Si-H bonds) contained in the molecule is 3 or more. The average number of such groups per molecule is more preferably 5 or more, and still more preferably 8 or more. Other conditions of the hydrogenpolyorganosiloxane, such as organic groups other than the hydrogen groups, bonding positions, the degree of polymerization, and the structure, are not particularly limited. When the degree of polymerization is expressed by the value of c + d + 2 in the above formula, the degree of polymerization is preferably in the range of 5 to 200, in particular, 10 to 120 for the reason that the composition that is obtained tends to exhibit still enhanced handleability. Specific examples of the useful hydrogenpolyorganosiloxanes include linear-skeleton hydrogenpolyorganosiloxanes containing 8 or more units having a Si-H bond (M^{H} or D^{H} units) and having a degree of polymerization in the range of 10 to 120.

The content of the component (B) may be such that the number of the crosslinking groups with respect to 1 mol of the curable functional groups (alkenyl groups) in the component (A) is in the range of, for example, 0.1 to 1.8 mol, specifically, in the range of 0.2 to 0.7 mol. The amount in which the component (B) is added may be designed in accordance with the amount of the curable functional groups in the component (A) so as to fall in an appropriate range based on the criteria described later. Compounds as the components (B) may be distinguished by, for example, the positions or the types of the crosslinking groups, and the degree of polymerization in the case of the hydrogenpolysiloxane. A single kind of a compound may be used, or a mixture of two or more kinds of compounds may be used. The component (B) may be a mixture of hydrogenpolysiloxanes with different degrees of polymerization.

The component (B) is a linear polyorganohydrogensiloxane that is capped with H₍₃₋ₐ₎R¹ₐSiO_{1/2} units or R¹₃SiO_{1/2} units at both terminals and has intermediate units consisting of at least one HR¹SiO_{2/2} unit and any number of R¹₂SiO_{2/2} unit(s). At least one hydrogen atom bonded to silicon atom is present in the intermediate units, and the remaining at least two may be present at the terminals or in the intermediate units.

Particularly preferred component (B) is a linear polymethylhydrogensiloxane (B1-1) that is capped with M units (trimethylsiloxane units) at both terminals and has intermediate units consisting solely of D^{H} units (methylhydrogensiloxane units), and a linear polymethylhydrogensiloxane (B1-2) that is capped with M units (trimethylsiloxane units) at both terminals, has intermediate units consisting solely of D units (dimethylsiloxane units) and D^{H} units (methylhydrogensiloxane units), and contains 0.1 to 3.0 mol of the methylhydrogensiloxane units per mol of the dimethylsiloxane units. The component (B) may be a single compound or a combination of two or more compounds.

The amount in which the component (B) is added is preferably such that the number of hydrogen atoms directly bonded to a silicon atom is 0.1 to 1.8 per one curable functional group (alkenyl group) in the component (A). If the number is smaller than 0.1, the curing rate may be insufficient. If the number is larger than 1.8, cured products may become too hard and post-curing properties may be adversely affected. In other words, the amount of the polyorganosiloxane having alkenyl groups (in particular, vinyl groups) in the molecule may be controlled based on the ratio (H/Vi ratio) of the amount of substance of Si-H bonds present in the hydrogenpolyorganosiloxane to the amount of substance of vinyl groups. The H/Vi ratio is more preferably in the range of 0.2 to 1.0, and still more preferably in the range of 0.3 to 0.7. Controlling the H/Vi ratio to 0.3 or more can achieve a sufficient curing rate and also offers higher adhesion with respect to various substrates. By controlling the H/Vi ratio to 0.7 or less, a sufficient amount of curing of the composition can be achieved and an appropriate hardness can be ensured, and also higher adhesion can be attained while maintaining heat resistance.

In the curable composition, for example, the component (B) may contain the crosslinking groups in an amount of 0.1 mol or more, specifically, 0.2 mol or more per mol of the curable functional groups in the component (A). For example, the component (B) may contain the crosslinking groups in an amount of 1.8 mol or less, specifically, 1 mol or less, more specifically, 0.7 mol or less per mol of the curable functional groups in the component (A).

### Component (C)

The composition of the present invention further includes, as a silicon compound, a siloxane compound (hereinafter, sometimes written simply as the "component (C)") that has at least two hydrogen atoms bonded to silicon atom in the molecule and has one hydrolyzable group bonded to a siloxane skeleton via a heteroatom-containing structure. The component (C) does not belong to the components (A) or the components (B).

The term "hydrogen atoms bonded to silicon atom" is the same as described with respect to the component (B).

The "heteroatom-containing structure" is a divalent functional group that contains at least one of oxygen, nitrogen, sulfur, and phosphorus. The structure thereof is not particularly limited as long as containing a heteroatom in a skeleton that connects the hydrolyzable group to the siloxane skeleton with the smallest number of atoms. Examples of the heteroatom-containing structures include divalent alkylene groups substituted by, for example, ether (-O-), amino (-NR- wherein R is a hydrogen atom or a monovalent hydrocarbon group), sulfide (-S-), sulfonyl (-SO₂-), phosphino (-PR-), ester (-O(C=O)-), or thioester (-S(C=O)-) in place of at least one -CH₂- moiety.

As used in the present specification, the term "hydrolyzable group" means a group that can undergo a hydrolysis reaction, more specifically, a group that can be detached from the main skeleton of the compound upon a hydrolysis reaction. Preferably, the component (C) contains only one hydrolyzable group in the molecule, and the group is bonded to the siloxane skeleton via the heteroatom-containing structure. Examples of the hydrolyzable groups include -OR', -OCOR', -O-N=CR'₂, - NR'₂, -NHR', epoxy, and halogen atoms (wherein R' denotes a substituted or unsubstituted C₁-C₄ alkyl group). For reasons, such as because the silicone composition will not corrode substrates and will be chemically stable, the hydrolyzable group is preferably -OR' (that is, an alkoxy group). Examples of R' include unsubstituted alkyl groups, such as methyl group, ethyl group, propyl group, isopropyl group, n-butyl group, and isobutyl group; and substituted alkyl groups, such as chloromethyl group. Among these, alkyl groups, in particular, unsubstituted alkyl groups are preferable, and methyl group or ethyl group is more preferable. That is, in a preferred embodiment, the hydrolyzable group is an alkoxy group, such as a methoxy group, an ethoxy group, a propoxy group, or a butoxy group. The hydrolysis of the hydrolyzable group may form a hydroxyl group, although not particularly limited thereto. Examples of the halogen atoms include fluorine atom, chlorine atom, bromine atom, and iodine atom, with chlorine atom being preferable.

The "siloxane skeleton" is a skeleton composed of an appropriate combination of siloxane-forming units, such as the M units and the D units described hereinabove. In the component (C), the skeleton of siloxane is not particularly limited and may be linear, branched, or cyclic. A cyclic siloxane skeleton is particularly preferable because selective synthesis and purification of a specific compound is possible.

The component (C) is exemplified by an organosilicon compound (C1) having hydrogen atoms bonded to silicon atom and a structure of the following formula (4) that is bonded to a silicon atom. 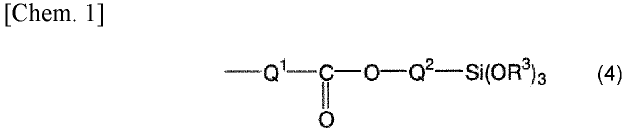 (wherein Q¹ denotes a linear or branched alkylene group that forms a C₂ or higher carbon chain between the silicon atom and the ester bond; Q² denotes a linear or branched alkylene group that forms a C₃ or higher carbon chain between the oxygen atom and the silicon atom in the structure; and R³ denotes a C₁-C₄ alkyl group or a 2-methoxyethyl group).

The component (C 1) may be a single kind of the above compound or a combination of two or more kinds of the above compounds.

The component (C1) undergoes an addition reaction with the component (A) during curing of the composition and is introduced into the siloxane structure crosslinked by the addition reaction of (A) and (B), and the structure of the formula (4) exhibits adhesion and contributes to the adhesion of the composition at room temperature.

Because of easy synthesis and easy handling, Q¹ is preferably an ethylene group or a 2-methylethylene group. Because of easy synthesis and easy handling, Q² is preferably a trimethylene group. R³ is preferably a methyl group or an ethyl group, particularly preferably a methyl group, because the structure provides good adhesion and the alcohol resulting from the hydrolysis is easily volatilized.

Because of easy synthesis, the above-described hydrogen atoms and the above-described structure that are features of (C1) are preferably bonded to separate silicon atoms. That is, the basic moiety of (C1) preferably forms a chain, branched, or cyclic siloxane skeleton. The number of Si-H bonds contained in (C1) is any number of 1 or greater and is preferably 2 or 3 in the case of a cyclic siloxane compound.

Examples of (C1) include reaction products of a cyclic organohydrogenpolysiloxane and a silane compound having an acrylic group or a methacrylic group. Such compounds are advantageous in that the synthetic route has been established and in that the number of Si-H bonds and the number of hydrolyzable groups per molecule can be easily controlled, and therefore properties of the whole of the composition can be uniformly controlled easily. More specific examples of (C1) include the following compounds:

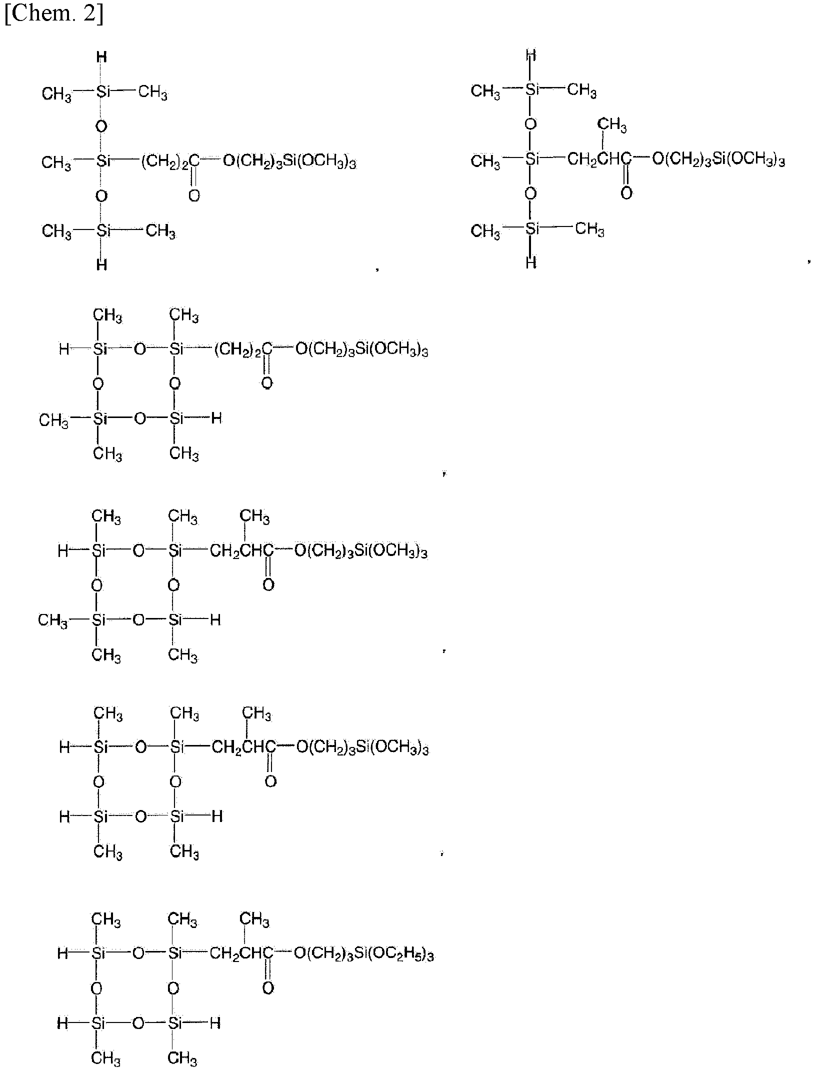

Examples of the components (C) further include compounds having hydrogen atoms bonded to silicon atom and a reactive organic functional group in the molecule, such as one illustrated below:

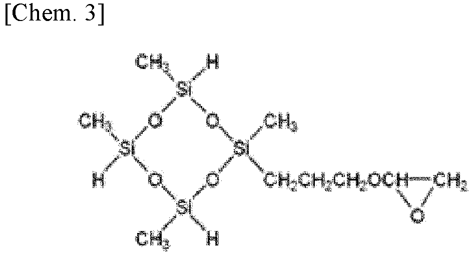

The amount of the component (C) in the composition is such that the total of the hydrogen atoms bonded to silicon atom contained in the component (B) and the component (C) is 0.1 to 2.0 equivalents relative to 1 equivalent of the alkenyl groups in the component (A), and the ratio of the number of hydrogen atoms bonded to silicon atom derived from the component (C) to the number of hydrogen atoms bonded to silicon atom in the whole of the composition is 0.2 or more. By controlling the quantitative relationship with the components (A) and (B) so as to fall in the above ranges, the adhesion to a substrate is further enhanced.

Regarding the relationship with the component (A), the total of the hydrogen atoms bonded to silicon atom contained in the component (B) and the component (C) is more preferably 0.4 to 1.8 equivalents relative to 1 equivalent of the alkenyl groups in the component (A). Regarding the relationship with the component (B), the ratio of the number of hydrogen atoms bonded to silicon atom derived from the component (C) to the number of hydrogen atoms bonded to silicon atom is more preferably 0.3 or more.

### Component (D)

The composition of the present invention includes a curing catalyst capable of catalyzing the crosslinking reaction between the component (A) and the component (B) (hereinafter, the catalyst is sometimes written simply as the "component (D)"). The curing catalyst that is used is a UV-active hydrosilylation platinum catalyst having a cyclodiene skeleton as a ligand. For example, trimethyl(methylcyclopentadienyl)platinum is dissolved beforehand into the siloxane polymer as required and is used as a mixture. The amount thereof is such that the amount of platinum element is 0.1 to 1000 ppm relative to the component (A). If the amount is less than 0.1 ppm, the composition will not be cured sufficiently. Any amount exceeding 1000 ppm is not expected to provide a corresponding enhancement in curing rate. In order to obtain a longer pot life depending on the use application, the activity of the catalyst may be suppressed by the addition of a reaction inhibitor. Some known reaction inhibitors for platinum group metals are acetylene alcohols, such as 2-methyl-3-butyn-2-ol, 3,5-dimethyl-1-hexyn-3-ol, and 1-ethynyl-2-cyclohexanol, diallyl maleate, and tertiary amines, such as tetramethylethylenediamine and pyridine.

[Curable polyorganosiloxane compositions] The curable polyorganosiloxane of the present invention contains the above components (A) to (D). In particular, the types of the components (A) and (B) may be appropriately selected from commercial products and known products in accordance with the desired properties. From the point of view of controlling, for example, the refractive index, it is preferable to introduce phenyl groups into the components (A) and (B). In this case, the introduction is preferably designed so that the refractive index of a cured product will be 1.56 or less.

Properties of the polyorganosiloxane composition of the present invention are not particularly limited as long as the components are uniformly mixed with one another and the composition has a fluidity that permits application to a substrate. The viscosity of the polyorganosiloxane composition may be controlled mainly by controlling the viscosity of the component (A) and is preferably in the range of 0.1 to 500 Pa s from the point of view of operability. The viscosity of the composition is more preferably in the range of 0.1 to 50 Pa·s. The polyorganosiloxane composition of the present invention has high stability and is easy to handle with little variation in viscosity even after long storage. Particularly preferably, the composition has a viscosity of 50 Pa·s or less after being stored under dark conditions at 80°C for one week.

The polyorganosiloxane composition may be a one-pack composition in which all the components have been mixed or may be a two-pack composition in which the component (B) and the component (D) are separated from each other. Whether the composition is a one-pack type or a two-pack type may be selected appropriately in view of, for example, workability and curing conditions, and the associated techniques are known to those skilled in the art.

The curable polyorganosiloxane composition of the present invention may contain additional components that are known, as long as the purpose and the effects of the composition are not impaired. Additives may be added appropriately, such as flame retardants, adhesion imparting agents, heat resistance imparting agents, diluents, organic solvents, and inorganic or organic pigments. Furthermore, siloxane resins that do not belong to the components (A), (B), and (C) may be added. Examples of such resins include polyorganosiloxanes having only one curable functional group, and polyorganosiloxanes having no curable functional group, such as dimethylsiloxane. These resins may be used as diluents.

### <Additional resins>

The curable polyorganosiloxane composition may further include a siloxane resin that does not belong to the components (A) to (C). Such a resin may also be used as a diluent to control the viscosity. Such a siloxane resin may be a siloxane resin that is composed of a combination of the M, D, T, and Q units and has no or only one curable functional group, in particular, a siloxane with only one curable functional group that is represented by the following formula (5):

R^{a}R₂Si-O-(SiR₂O)ₙ-SiR₃ .. (5)

(wherein R^{a}, R, and n are as defined in the formula (2), and R has no curable functional group); or a siloxane with no curable functional group that is represented by the formula (6):

R₃Si-O-(SiR₂O)ₙ-SiR₃ ··· (6)

(wherein R and n are as defined in the formula (2), and R has no curable functional group). The use of such a siloxane resin makes it possible to control the hardness of a cured product of the curable polyorganosiloxane composition and to control the viscosity of the composition, and is therefore a tool for dealing with varied levels of handleability and other properties that are required.

For example, the curable polyorganosiloxane composition may contain such a resin in an amount of 50 parts by mass or less, specifically, 0.1 to 50 parts by mass, more specifically, 1 to 30 parts by mass, with respect to 100 parts by mass of the component (A).

### <Polyorganohydrogensiloxanes having two hydrogen atoms bonded to silicon atom in the molecule>

The composition may further include a polyorganohydrogensiloxane having two hydrogen atoms bonded to silicon atom in the molecule. Such a siloxane may function as a chain extender by undergoing an addition reaction with the component (A). Examples of such siloxanes are the same as described with respect to the component (B), except that they have two hydrogen atoms bonded to silicon atom in the molecule. The molecule of such a siloxane preferably has two units represented by H₍₃₋ₐ₎R¹ₐSiO_{1/2} or HR¹SiO_{2/2} in the general formula (3) so that the number of Si-H bonds will be two.

The siloxane skeleton of this component may be linear, branched, or cyclic and is preferably linear. Furthermore, the siloxane of this component is more preferably a linear polyorganohydrogensiloxane that is capped with an R⁵₃SiO_{1/2} unit independently at each of the two terminals and has intermediate units consisting solely of R⁵₂SiO_{2/2} units (wherein R⁵ independently at each occurrence is a hydrogen atom or a monovalent hydrocarbon group having no aliphatic unsaturated bond, and two R⁵ per molecule are hydrogen atoms). The hydrogen atoms bonded to silicon atom may be present at the terminals or in the intermediate units and are preferably present at the terminals. Thus, the siloxane of this component is particularly preferably a polymethylhydrogensiloxane that is capped with M^{H} units (dimethylhydrogensiloxane units) at both terminals and has intermediate units consisting solely of D units (dimethylsiloxane units).

### <Adhesion imparting agents>

The curable polyorganosiloxane composition may further include an adhesion imparting agent as long as the object and the advantageous effects of the present invention are not impaired. The adhesion imparting agent is a component that enhances the adhesion of a cured product of the composition with respect to substrates, such as glass, metals, and plastics. Examples of the adhesion imparting agents include metal alkoxides, compounds having a hydrolyzable silyl group, compounds having a hydrolyzable silyl group and a reactive organic functional group in the molecule, compounds having a hydrogen atom bonded to silicon atom and a divalent aromatic group in the molecule, compounds having a hydrogen atom bonded to silicon atom and a reactive organic functional group in the molecule, and/or partial hydrolytic condensates thereof. Examples of the metal alkoxides include aluminum alkoxides, such as aluminum triethoxide, aluminum tripropoxide, and aluminum tributoxide; and titanium alkoxides, such as titanium tetraethoxide, titanium tetrapropoxide, titanium tetraisopropoxide, titanium tetrabutoxide, titanium tetraisobutoxide, and titanium tetraisopropenyl oxide. Examples of the organic compounds as the adhesion imparting agents include amino group-containing silanes, isocyanurates, and carbasilatrane compounds. Specific examples include oligomers of tetraethoxysilane and tetramethoxysilane, vinyltrimethoxysilane, vinyltriethoxysilane, 3-glycidoxypropyltrimethoxysilane, 3-glycidoxypropyltriethoxysilane, 3-glycidoxypropylmethyldimethoxysilane, 3,4-epoxycyclohexylethyltrimethoxysilane, 3-acryloxypropyltrimethoxysilane, 3-methacryloxypropyltrimethoxysilane, 3-acryloxypropylmethyldimethoxysilane, 3-methacryloxypropylmethyldimethoxysilane, and 3-methacryloxypropylmethyldiethoxysilane. In order to prevent an increase in haze particularly at high temperature and high humidity, these components are preferably added in an amount of less than 1 part by mass with respect to 100 parts by mass of the component (A) that is the base polymer.

Examples of the adhesion imparting agents further include the following.
(E1) Organosilicon compounds having a Si(OR³)ₙ group and an epoxy-containing group, and/or partial hydrolytic condensates thereof;
(E2) Silane compounds having a Si(OR³)ₙ group and an aliphatic unsaturated hydrocarbon group, and/or partial hydrolytic condensates thereof; and
(E3) Tetraalkoxysilane compounds represented by Si(OR⁴)₄, and/or partial hydrolytic condensates thereof.
(In the above formulas, R³ denotes a C₁-C₄ alkyl group or a 2-methoxyethyl group; R⁴ denotes a C₁-C₃ alkyl group; and n is an integer of 1 to 3.)

The components (E1), the components (E2), and the components (E3) each may be used singly, or two or more compounds may be used in combination.

### «(E1)»

The component (E1) is introduced into the crosslinked siloxane structure by the co-hydrolytic condensation reaction of its silicon-bonded alkoxy group with the silicon-bonded alkoxy group in (E2) and/or (E3). The epoxy group in this component exhibits adhesion and contributes to the enhancement in the adhesion of the composition at room temperature, in particular, the adhesion with respect to plastics.

To ensure good adhesion, R³ is preferably a methyl group or an ethyl group, and particularly preferably a methyl group. The letter n is preferably 2 or 3. For example, preferred epoxy-containing groups are aliphatic epoxy-containing groups containing an ether oxygen atom, such as 3-glycidoxypropyl group, and alicyclic epoxy-containing groups, such as 2-(3,4-epoxycyclohexyl)ethyl group; these groups are advantageous in that the synthesis is easy and the groups have no hydrolyzability and exhibit excellent adhesion. There may be two or more Si(OR³)ₙ groups in the molecule. The number of the OR³ groups in the molecule is preferably 2 or more. The OR³ group and the epoxy-containing group may be bonded to the same silicon atom or may be bonded to different silicon atoms.

Examples of (E1) include 3-glycidoxypropyl group-containing alkoxysilanes, such as 3-glycidoxypropyltrimethoxysilane, 3-glycidoxypropyltriethoxysilane, and 3-glycidoxypropyl(methyl)dimethoxysilane; 2-(3,4-epoxycyclohexyl)ethyl group-containing alkoxysilanes, such as 2-(3,4-epoxycyclohexyl)ethyltrimethoxysilane, 2-(3,4-epoxycyclohexyl)ethyltriethoxysilane, and 2-(3,4-epoxycyclohexyl)ethyl(methyl)dimethoxysilane; partial hydrolytic condensates of these silanes in which n is 2 or greater; and carbon/silicon bifunctional siloxanes that are chain or cyclic methylsiloxanes substituted by a trimethoxysiloxy group or a 2-(trimethoxysilyl)ethyl group and the epoxy-containing group described hereinabove in place of part of the methyl groups.

### <<(E2)>>

The component (E2) undergoes an addition reaction with the component (B) during curing of the composition and is introduced into the siloxane structure crosslinked by the addition reaction of (A) and (B). The alkoxy groups in side chains of the component exhibit adhesion and contribute to the enhancement in the adhesion of the composition at room temperature, in particular, the adhesion with respect to metals. Furthermore, the alkoxy groups in (E2) contribute to introducing (E1) and/or (E3) into the crosslinked siloxane structure by undergoing a co-hydrolytic condensation reaction with the alkoxy groups in (E1) and/or (E3). The component (E2) is preferably a silane compound having a Si(OR³)ₙ group and one aliphatic unsaturated hydrocarbon group and/or a partial hydrolytic condensate of the compound.

To ensure good adhesion, R³ is preferably a methyl group or an ethyl group, and particularly preferably a methyl group. The letter n is preferably 2 or 3. The aliphatic unsaturated hydrocarbon group is preferably a monovalent group. The aliphatic unsaturated hydrocarbon group may be directly bonded to a silicon atom as in the case of an alkenyl group, such as vinyl, allyl, or 3-butenyl, or may be bonded in such a manner that an unsaturated acyloxy group is bonded to a silicon atom via three or more carbon atoms as in the case of 3-acryloxypropyl or 3-methacryloxypropyl. For example, the unsaturated hydrocarbon-containing group is preferably a vinyl group or a methacryloxypropyl group because of easy synthesis and easy handling. There may be two or more Si(OR³)ₙ groups in the molecule. The number of the OR³ groups in the molecule is preferably 2 or more. The OR³ group and the aliphatic unsaturated hydrocarbon group may be bonded to the same silicon atom or may be bonded to different silicon atoms.

Examples of (E2) include alkenylalkoxysilanes, such as vinyltrimethoxysilane, vinyltriethoxysilane, vinyltris(2-methoxyethoxy)silane, methylvinyldimethoxysilane, allyltrimethoxysilane, allyltriethoxysilane, and methylallyldimethoxysilane, and/or partial hydrolytic condensates thereof; and (meth)acryloxypropyl(methyl)di- and (meth)acryloxypropyltri-alkoxysilanes, such as 3-acryloxypropyltrimethoxysilane, 3-acryloxypropyltriethoxysilane, 3-acryloxypropyl(methyl)dimethoxysilane, 3-methacryloxypropyltrimethoxysilane, 3-methacryloxypropyltriethoxysilane, and 3-methacryloxypropyl(methyl)dimethoxysilane, and/or partial hydrolytic condensates thereof.

### <<(E3)>>

The component (E3) is a component that further enhances the adhesion of the composition with respect to metals at room temperature. Examples of R⁴ include linear or branched alkyl groups, such as methyl, ethyl, propyl, and isopropyl. Methyl group and ethyl group are preferable because such compounds are readily available, easy to handle, and significantly effective in adhesion enhancement. The component (E3) may be a tetraalkoxysilane compound itself but is preferably a partial hydrolytic condensate of a tetraalkoxysilane compound because it has excellent hydrolyzability and low toxicity.

### <<Additional adhesion imparting agents>>

Examples of the additional adhesion imparting agents other than (E1) to (E3) include metal alkoxides, for example, aluminum alkoxides, such as aluminum triethoxide, aluminum tripropoxide, and aluminum tributoxide; titanium alkoxides, such as titanium tetraethoxide, titanium tetrapropoxide, titanium tetraisopropoxide, titanium tetrabutoxide, titanium tetraisobutoxide, and titanium tetraisopropenyl oxide; zirconium acylates, such as zirconium octanoate, zirconium tetra(2-ethylhexanoate), and zirconium stearate; zirconium alkoxides, such as n-propyl zirconate and n-butyl zirconate (except zirconium chelates); and zirconium chelates, such as tributoxyzirconium acetylacetonate, dibutoxyzirconium bis(ethyl acetoacetate), zirconium tetraacetylacetonate, zirconium monoacetylacetonate, and zirconium ethyl acetoacetate.

Examples of the additional adhesion imparting agents further include compounds that have a hydrolyzable silyl group and a reactive organic functional group in the molecule and/or partial hydrolytic condensates thereof (except (E1) to (E3)), such as: 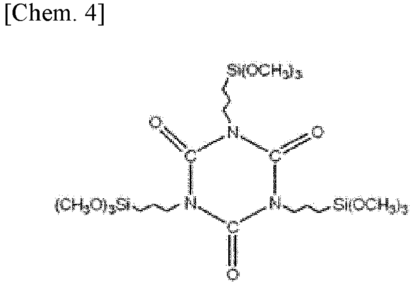 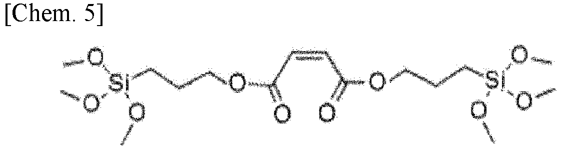 ; and compounds that have a hydrogen atom bonded to silicon atom and a divalent aromatic group in the molecule, such as: 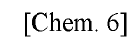 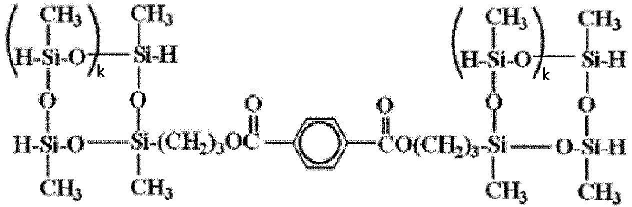 (wherein k is an integer of 1 to 3). The combined use of the additional adhesion imparting agent can further increase the bond strength.

For example, the content of the adhesion imparting agent in the curable polyorganosiloxane composition may be 10 parts by mass or less, specifically, 0.01 to 10 parts by mass, more specifically, 0.1 to 5 parts by mass, with respect to 100 parts by mass of the component (A). The adhesion imparting agents may be used singly, or two or more may be used as a mixture.

### <Solvents>

The curable polyorganosiloxane composition may include a solvent. In this case, the curable polyorganosiloxane composition may be used as a solution in an appropriate solvent with a desired concentration in accordance with the use application and the purpose thereof. For example, the concentration of the solvent may be 80 parts by mass or less, 50 parts by mass or less, 30 parts by mass or less, or 20 parts by mass or less with respect to 100 parts by mass of the curable polyorganosiloxane composition. The use of a solvent is preferable from the point of view of controlling the viscosity of the curable composition. The addition of a solvent may improve the handleability of the curable composition.

An aspect of the present invention resides in an adhesive including the curable polyorganosiloxane composition. The adhesive preferably includes the adhesion imparting agent in addition to the curable polyorganosiloxane composition.

Articles in which the curable polyorganosiloxane composition of the present invention is used as an adhesive may be of any shape without limitation as long as the articles have a joint between the cured product of the composition and the substrate. For example, an aspect resides in a method for producing an article that includes a joint between a substrate and a cured product of the composition, the method including a step of providing a part including the substrate, and the composition; a step of applying the composition to a surface of the substrate; and a step of curing the composition to bond the substrate and the cured product of the composition to each other.

The materials of the substrates to which the adhesive containing the curable polyorganosiloxane composition of the present invention is applied are not particularly limited. Examples of the substrates that may be used include metals, such as aluminum, copper, nickel, iron, brass, and stainless steel; engineering plastics, such as epoxy resins, polyester resins including polyethylene terephthalate and polybutylene terephthalate (PBT) resins, polycarbonate resins, acrylic resins, polyimide resins, phenol resins, polyamide resins, polyphenylene sulfide (PPS) resins, and modified polyphenylene ether (PPE) resins; and glass. Where necessary, primer treatment may be performed on, for example, the wall surfaces of voids in accordance with a conventional technique. Properties, such as shape and thickness, of the substrates are not particularly limited.

The adhesive including the curable polyorganosiloxane composition is applied to a bonding portion of the surface of a part including a substrate, with a desired thickness by such a method as dropping, injection, casting, extrusion from a container, coating, such as bar coating or roll coating, screen printing, dipping, brushing, spraying, or dispensing. These techniques are known to those skilled in the art. The composition may be applied uniformly to the whole of the surface of the part or may be applied nonuniformly or partially, such as in lines, stripes, or dots. The composition is usually applied to a thickness of 0.01 to 3 mm, preferably 0.05 to 2 mm.

The composition may be cured by UV irradiation. The irradiation dose is preferably 100 to 10,000 mJ/cm², more preferably 300 to 6,000 mJ/cm², and still more preferably 500 to 4,000 mJ/cm². Incidentally, the irradiation dose is a value measured with respect to UVA. Here, UVA refers to ultraviolet rays in the range of 315 to 400 nm. The composition has good curability when irradiated with ultraviolet rays having an ultraviolet wavelength, for example, a wavelength in the range of 250 to 450 nm. Examples of the light sources that emit ultraviolet rays having such wavelengths include high-pressure mercury lamp (UV-7000) and metal halide lamp (UVL-4001M3-N1) manufactured by Ushio Inc., metal halide lamp (JM-MTL 2KW) manufactured by JM tech, Korea, UV irradiation lamp (OSBL360) manufactured by Mitsubishi Electric Corporation, UV irradiation machine (UD-20-2) manufactured by Japan Storage Battery Co., Ltd., fluorescent lamp (FL-20BLB) manufactured by TOSHIBA CORPORATION, H Bulb, H plus Bulb, V Bulb, D Bulb, Q Bulb, and M Bulb manufactured by Heraeus, and LED lamp (HLDL-155UV) manufactured by CCS Inc.

The curing time of the composition depends on the UV irradiation dose but is generally 30 minutes or less. The progress of the curing of the composition may be judged visually or may be quantitatively estimated by measuring the storage elastic modulus G' and the loss elastic modulus G". Short curing time and excellent handleability can be advantageously obtained when, for example, an equalization between storage elastic modulus G' and loss elastic modulus G" is reached in 30 minutes or less at 23°C after UV irradiation.

The cured state of the composition may be evaluated by, for example, visual observation or touch, and may also be quantitatively estimated by measuring how much a needle penetrates into the composition (penetration) under certain conditions. The penetration is measured based on JIS K 6249. In the composition of the present invention, the penetration of a cured product is preferably 10 or more.

The articles that use the curable polyorganosiloxane composition of the present invention as an adhesive or a sealant are excellent in durability performance, such as water resistance, of the j oint face or the seal, and therefore can be suitably used as various parts in the field of electronic materials. The curable polyorganosiloxane composition of the present invention is also excellent in handleability, such as pot life and stability. Thus, for example, the composition can be used as an adhesive for bonding in image display devices, such as liquid crystal, plasma, and organic EL image display devices, or as a sealant for sealing in LED devices or OLED devices.

### EXAMPLES

The composition of the present invention will be described in greater detail by way of the following Examples. However, the present invention is not limited to the embodiments described in Examples.

The materials used in Examples and Comparative Examples are as follows. Here, the symbols, such as M, D, and D^{H}, that describe siloxane compounds are the same as defined hereinabove. Furthermore, the amounts added to the composition are indicated as parts by mass unless otherwise specified.

### <Polyorganosiloxane resins: components (A)>

α,ω-Divinylpolydimethylsiloxane; viscosity 400 mPa·s
α,ω-Divinylpolydimethylsiloxane; viscosity 3000 mPa·s
α,ω-Divinylpolydimethylsiloxane; viscosity 12000 mPa·s

### <Organohydrogenpolysiloxanes: components (B)>

Organohydrogenpolysiloxanes having the following average compositional formulas were used as the components (B).
·MD₈₀D^{H}₂₀M
·MD₁₇D^{H}₂₃M
·M^{H}D₄₂D^{H}₈M^{H}
·M^{H}D^{H}₃D₂₂M^{H}

### <Silane compound: component (C)>

Addition reaction product of cyclic siloxane represented by DD^{H}₃ with 3-methacryloxypropyltrimethoxysilane

### <Platinum catalyst: component (D)>

1% Mixture of (trimethyl)methylcyclopentadienyl platinum with α,ω-divinylpolydimethylsiloxane (viscosity 3000 mPa s)

### <Other components>

In Comparative Examples, the following components were used as required.
·γ-Glycidoxypropylmethyldimethoxysilane
·3-Methacryloxypropyltrimethoxysilane
·Addition reaction product of M^{H}D₇D^{H}₂M^{H} with vinyltrimethoxysilane
·α-Vinylpolydimethylsiloxane: siloxane having a composition represented by MD₂₀M^{Vi}
·Organohydrogenpolysiloxane represented by average composition MD₂₀M^{H}
·Organohydrogenpolysiloxane represented by average composition M^{H}D₂₀M^{H}

### <Preparation of curable polyorganosiloxane compositions>

[Example 1] 1.15 g of the organohydrogenpolysiloxane (B) having the average compositional formula MD₈₀D^{H}₂₀M, 2.3 g of the addition reaction product (C) of cyclic siloxane DD^{H}₃ with 3-methacryloxypropyltrimethoxysilane, and 0.33 g of the 1% mixture (D) of (trimethyl)methylcyclopentadienyl platinum with 3000 mPa·s viscosity α,ω-divinylpolydimethylsiloxane were added to 100 g of 400 mPa s viscosity α,ω-divinylpolydimethylsiloxane (A). The mixture was stirred to give a composition 1.

### [Examples 2 to 8]

Compositions 2 to 8 were obtained in the same manner as in Example 1, except that the components (A) to (D) and the amounts thereof in Example 1 were changed as described in the table below.

**[Table 1]**

| | | Ex. 1 | Ex. 2 | Ex. 3 | Ex. 4 | Ex. 5 | Ex. 6 | Ex. 7 | Ex. 8 |
|---|---|---|---|---|---|---|---|---|---|
| (A) | Di-vinyl-ended, viscosity 400 mPa.s | 100 | | | | | | | |
| | Di-vinyl-ended, viscosity 3000 mPa.s | | 100 | 100 | 100 | 100 | 100 | 100 | |
| | Di-vinyl-ended, viscosity 12000 mPa.s | | | | | | | | 100 |
| (B) | MD₈₀D^{H}₂₀M | 1.15 | 0.51 | 0.74 | 1 | | | | 0.35 |
| | MD₁₇D^{H}₂₃M | | | | | 0.31 | | | |
| | M^{H}D₄₂D^{H}₈M^{H} | | | | | | 0.60 | | |
| | M^{H}D^{H}₃D₂₂M^{H} | | | | | | | 0.61 | |
| (C) | Reaction product of DD^{H}₃ with 3-methacryloxypropyltrimethoxysilane | 2.3 | 1.02 | 0.74 | 0.3 | 0.62 | 1.20 | 1.22 | 0.7 |
| (D) | 1% Mixture of (trimethyl)methylcyclopentadienyl platinum with di-vinyl-ended 3000 mPa·s viscosity siloxane | 0.33 | 0.33 | 0.33 | 0.33 | 0.33 | 0.33 | 0.33 | 0.33 |
| Total | | 103.78 | 101.86 | 101.81 | 101.63 | 101.26 | 102.13 | 102.16 | 101.38 |
| | H/Vi ratio | 0.62 | 0.65 | 0.60 | 0.50 | 0.64 | 0.76 | 0.75 | 0.70 |
| | Molar ratio (%) of SiH derived from component (C) relative to all SiH | 71.50 | 71.50 | 55.64 | 27.34 | 44.30 | 72.16 | 73.84 | 71.50 |

### [Comparative Example 1]

A composition was obtained in the same manner as in Example 1, except that the amount of the component (B) used in Example 1 was changed to 1.24 parts by mass, and the component (C) was not added.

### [Comparative Example 2]

A composition was obtained in the same manner as in Comparative Example 1, except that the amount of the component (B) MD₅₀D^{H}₂₀M used in Comparative Example 1 was changed to 0.78 parts by mass, and 14.04 parts by mass of the organohydrogenpolysiloxane represented by the average composition MD₂₀M^{H} was added.

### [Comparative Example 3]

A composition was obtained in the same manner as in Comparative Example 1, except that the amount of the component (B) MD₈₀D^{H}₂₀M used in Comparative Example 1 was changed to 0.5 parts by mass, and 3.1 parts by mass of the organohydrogenpolysiloxane represented by the average composition M^{H}D₂₀M^{H} was added.

### [Comparative Example 4]

A composition was obtained in the same manner as in Comparative Example 1, except that the amount of the component (A) used in Comparative Example 1 was changed to 50 parts by mass, and 50 parts by mass of α-vinylpolydimethylsiloxane having the composition MD₂₀M^{Vi} was added, and further that the amount of the component (B) was changed to 1.35 parts by mass.

### [Comparative Example 5]

A composition was obtained in the same manner as in Comparative Example 1, except that 1 part by mass of γ-glycidoxypropylmethyldimethoxysilane was further added to the formulation of Comparative Example 1.

### [Comparative Example 6]

A composition was obtained in the same manner as in Comparative Example 1, except that the amount of the component (B) used in Comparative Example 1 was changed to 1.7 parts by mass, and 1 part by mass of 3-methacryloxypropyltrimethoxysilane was added.

### [Comparative Example 7]

A composition was obtained in the same manner as in Comparative Example 1, except that the amount of the component (B) used in Comparative Example 1 was changed to 0.51 parts by mass, and 1 part by mass of the addition reaction product of M^{H}D₇D^{H}₂M^{H} with vinyltrimethoxysilane was added.

The compositions of Comparative Examples 1 to 7 have the chemical compositions described in the table below.

**[Table 2]**

| | | Comp. Ex. 1 | Comp. Ex. 2 | Comp. Ex. 3 | Comp. Ex. 4 | Comp. Ex. 5 | Comp. Ex. 6 | Comp. Ex. 7 |
|---|---|---|---|---|---|---|---|---|
| (A) | Di-vinyl-ended, viscosity 400 mPa.s | | | | | | | |
| | Di-vinyl-ended, viscosity 3000 mPa.s | 100 | 100 | 100 | 50 | 100 | 100 | 100 |
| | Di-vinyl-ended, viscosity 12000 mPa.s | | | | | | | |
| (B) | MD₈₀D^{H}₂₀M | 1.24 | 0.78 | 0.5 | 1.35 | 1.24 | 1.70 | 0.51 |
| | MD₁₇D^{H}₂₃M | | | | | | | |
| | M^{H}D₄₂D^{H}₈M^{H} | | | | | | | |
| | M^{H}D^{H}₃D₂₂M^{H} | | | | | | | |
| (C) | Reaction product of DD^{H}₃ with 3-methacryloxypropyltrimethoxysilane | | | | | | | |
| (D) | 1% Mixture of (trimethyl) methylcyclopentadienyl platinum with di-vinyl-ended 3000 mPa s viscosity siloxane | 0.33 | 0.33 | 0.33 | 0.33 | 0.33 | 0.33 | 0.33 |
| Oth ers | MD₂₀M^{vi} | | | | 50 | | | |
| | MD₂₀M^{H} | | 14.04 | | | | | |
| | M^{H}D₂₀M^{H} | | | 3.1 | | | | |
| | γ-Glycidoxypropylmethyldimethoxysilane | | | | | 1.00 | | |
| | 3-Methacryloxypropyltrimethoxysilane | | | | | | 1.00 | |
| | Reaction product of M'D7D'2M' with vinyltrimethoxysilane | | | | | | | 1.00 |
| Total | | 101.57 | 115.15 | 103.93 | 101.68 | 102.57 | 103.03 | 101.84 |
| H/Vi ratio | | 0.45 | 1.39 | 0.70 | 0.60 | 0.45 | 0.40 | 0.60 |
| Molar ratio (%) of SiH derived from component (C) relative to all SiH | | 0.00 | 0.00 | 0.00 | 0.00 | 0.00 | 0.00 | 0.00 |

### [Test Example 1: Penetration]

The silicone gel compositions obtained in Examples and Comparative Examples were UV irradiated for 10 seconds using HLDL-155UV manufactured by CCS Inc. while adjusting the value to 100 mW. After the irradiation, the compositions were heated at 60°C for 30 minutes. The cured products were tested in accordance with JIS K 6249 to measure the penetration. The penetration under the above conditions is preferably 10 or more to prevent stress on displays.

### [Test Example 2: Viscosity]

The viscosity was measured at 23°C using a rotational viscometer (VISMETRON VDA-L) (manufactured by SHIBAURA SYSTEMS CO., LTD.) at 60 rpm. No. 2 rotor was used for the range of 400 cP and below, No. 3 rotor for the range of more than 400 to 1,500 cP, and No. 4 rotor for the range of more than 1,500 cP. The initial viscosity at the time of preparation and the viscosity after storage at 80°C for one week were measured with respect to each of the compositions.

### [Test Example 3: Shear strength]

### [Test Example 4: Cohesive failure ratio (CF%)]

Two 1.1 mm thick glass plates, or one such a glass plate and one polycarbonate substrate were used. The composition was dropped onto the glass while using a spacer so that the dimensions of the composition would be 26 mm x 10 mm and the thickness would be 300 µm. Next, 100 mW LED light with a wavelength of 365 nm was applied from above the composition for 10 seconds, and the glass or the polycarbonate substrate was bonded. The unit was allowed to stand at 23°C for 24 hours to give a shear test specimen. A tensile test was performed at a stress rate of 10 mm/min using a tensile tester (AG-IS) manufactured by Shimadzu Corporation. The shear strength (MPa) was thus measured. Furthermore, the area S (mm²) of the cohesively failed portion of the UV-cured resin composition on the substrate was determined, and the cohesive failure ratio (%) was calculated from (100 × S)/(10 × 26).

### [Test Example 5: Crosspoint]

The composition was discharged onto a lower parallel quartz plate, and an upper parallel plate (diameter: 8 mm) was overlaid to sandwich the composition with a thickness of 300 µm. Using a viscoelastometer (MCR302) (manufactured by Anton Paar Japan K.K.), the storage elastic modulus G' (Pa) and the loss elastic modulus G" (Pa) were measured every second at 23°C, a frequency of 1 Hz, and a strain of 1%. The time (minutes) until the storage elastic modulus G' and the loss elastic modulus G" became equal was determined as the G'G" crosspoint and was taken as the curing time of the composition.

### [Test Example 6: Haze]

The haze was measured in accordance with JIS K 7136 using NDH5000 manufactured by NIPPON DENSHOKU INDUSTRIES Co., Ltd.

**[Table 3]**

| | Ex. 1 | Ex. 2 | Ex. 3 | Ex. 4 | Ex. 5 | Ex. 6 | Ex. 7 | Ex. 8 |
|---|---|---|---|---|---|---|---|---|
| Penetration | 35.4 | 47.4 | 36.8 | 38.1 | 34.1 | 33.1 | 32 | 35.9 |
| Initial viscosity Pa.s | 0.5 | 4.0 | 4.0 | 4.1 | 3.9 | 4.1 | 4.0 | 14.6 |
| Viscosity after 1 week at 80°C | 0.6 | 9.1 | 6.4 | 23.0 | 100 | 8.5 | 8.7 | 28.7 |
| Shear strength with glass Mpa | 0.1 | 0.3 | 0.3 | 0.1 | 0.3 | 0.4 | 0.4 | 0.3 |
| CF% | 100 | 100 | 100 | 100 | 100 | 100 | 100 | 100 |
| Shear strength with PC Mpa | 0.1 | 0.3 | 0.3 | 0.2 | 0.3 | 0.5 | 0.3 | 0.3 |
| CF% | 100 | 100 | 100 | 100 | 100 | 100 | 100 | 100 |
| Crosspoint, see | 373 | 577 | 337 | 450 | 371 | 584 | 652 | 524 |
| Initial haze | <0.1 | <0.1 | <0.1 | <0.1 | <0.1 | <0.1 | <0.1 | <0.1 |
| Haze after 1 week at 85°C and 85% | <0.1 | <0.1 | <0.1 | <0.1 | <0.1 | <0.1 | <0.1 | <0.1 |

| | Comp. Ex. 1 | Comp. Ex. 2 | Comp. Ex. 3 | Comp. Ex. 4 | Comp. Ex. 5 | Comp. Ex. 6 | Comp. Ex. 7 |
|---|---|---|---|---|---|---|---|
| Penetration | 27.2 | 79.5 | 61.4 | 32.8 | 38 | 15.4 | 40.5 |
| Initial viscosity Pa.s | 4.0 | 2.7 | 3.7 | 1.9 | 4.0 | 4.0 | 4.1 |
| Viscosity after 1 week at 80°C | 6.6 | 4.8 | 5.9 | 2.7 | 8.1 | gel | 9.3 |
| Shear strength with glass Mpa | 0.2 | 0.1 | 0.2 | 0.1 | 0.1 | 0.2 | 0.3 |
| CF% | 100 | 70 | 10 | 100 | 100 | 100 | 100 |
| Shear strength with PC Mpa | 0.1 | 0.1 | 0.1 | 0.1 | 0.2 | 0.1 | 0.1 |
| CF% | 0 | 0 | 0 | 0 | 70 | 0 | 0 |
| Crosspoint, see | 210 | 500 | 529 | 200 | 610 | 656 | 534 |
| Initial haze | <0.1 | <0.1 | <0.1 | <0.1 | <0.1 | <0.1 | <0.1 |
| Haze after 1 week at 85°C and 85% | <0.1 | <0.1 | <0.1 | <0.1 | >10 | >10 | <0.1 |

From Table 3, Examples 1 to 8 in which the formulation involved the specific component (C) gave cured products with appropriate hardness in a sufficiently short curing time. Furthermore, the increase in viscosity was small even under the accelerated test conditions, that is, excellent storage stability was attained. Furthermore, the compositions of Examples 1 to 8 had 100% cohesive failure ratio on both the glass and the polycarbonate substrate and were therefore demonstrated to have high adhesion. In contrast, adhesion to the polycarbonate was not obtained in Comparative Examples that did not involve any compounds corresponding to the components (C). Furthermore, the compositions of Comparative Examples 5 and 6, which only contained a silane compound that does not correspond to the component (C), had an increased haze value and were unsuited for optical applications.

### INDUSTRIAL APPLICABILITY

The composition of the present invention is a silicone compound with excellent pot life, adhesion, curability, and reliability, and is useful as an adhesive. Thus, the composition of the present invention is useful for the manufacturing of displays and LEDs using optical bonding techniques.

## Claims

1. A UV-curable silicone composition comprising:
(A) an organopolysiloxane containing at least two alkenyl groups bonded to silicon atom in the molecule;
(B) a linear organohydrogenpolysiloxane represented by the following formula and having at least three hydrogen atoms bonded to silicon atom in the molecule, (H₍₃₋ₐ₎R¹ₐSiO_{1/2})_{b}(R¹₃SiO_{1/2})_{2-b}(HR¹SiO_{2/2})_{c}(R¹₂SiO_{2/2})_{d}
(wherein R¹ independently at each occurrence denotes an unsubstituted or substituted, monovalent hydrocarbon group having no aliphatic unsaturated bond, a is 1 or 2, b is 0, 1, or 2, c is a number of 1 or greater, and d is a number of 0 or greater);
(C) a siloxane compound (not belonging to (A) or (B)) having at least two hydrogen atoms bonded to silicon atom in the molecule and having one hydrolyzable group bonded to a siloxane skeleton via a heteroatom-containing structure; and
(D) a UV-active hydrosilylation platinum catalyst having a cyclodiene skeleton as a ligand,
the UV-curable silicone composition being such that the total of the hydrogen atoms bonded to silicon atom contained in the component (B) and the component (C) is 0.1 to 2.0 equivalents relative to 1 equivalent of the alkenyl groups in the component (A), and the ratio of the number of hydrogen atoms bonded to silicon atom derived from the component (C) to the number of hydrogen atoms bonded to silicon atom in the whole of the composition is 0.2 or more.

2. The UV-curable silicone composition according to claim 1, wherein the component (A) is a linear organopolysiloxane.

3. The UV-curable silicone composition according to claim 1, wherein the component (D) is trimethyl(methylcyclopentadienyl)platinum.

4. The UV-curable silicone composition according to claim 1, wherein the component (C) is a reaction product of a cyclic organohydrogenpolysiloxane with a silane compound having an acrylic group or a methacrylic group.

5. The UV-curable silicone composition according to claim 1, which has a penetration of 10 or more after being cured.

6. The UV-curable silicone composition according to claim 1, wherein an equalization between storage elastic modulus G' and loss elastic modulus G" is reached in 30 minutes or less at 23°C after UV irradiation.

7. The UV-curable silicone composition according to claim 1, which has a viscosity of 50 Pa·s or less after being stored under dark conditions at 80°C for one week.

8. The UV-curable silicone composition according to claim 1, wherein the components (A) and (B) both have a phenyl group and the refractive index of a cured product is 1.56 or less.

9. The UV-curable silicone composition according to any one of claims 1 to 8, which is used for bonding or sealing in an image display device.

10. An image display device having a joint formed using the UV-curable silicone composition according to any one of claims 1 to 8.

11. An LED device having a seal formed using the UV-curable silicone composition according to any one of claims 1 to 8.
